# EUROPEAN PATENT APPLICATION

(11) **EP 1 837 319 A2**
(43) Date of publication of application: **26.09.2007**
(21) Application number: 07005030.7
(22) Date of filing: 12.03.2007
(51) Int. Cl.: C04B 41/61, C23C 16/30, C23C 16/40

(54) **Products in the form of tiles or slabs consisting of agglomerated stone surface-treated by low-temperature polymerisation of an organic or inorganic film**

(30) Priority: 24.03.2006 IT MI20060550
(71) Applicant: QUARELLA S.p.A., 37135 Verona (IT)
(72) Inventor: Godi, Alessandro, 37135 Verona (IT); Tassone, Pierpaolo, 37135 Verona (IT)
(74) Representative: Minoja, Fabrizio

(57) **Abstract**

This invention relates to the low-temperature polymerisation of an organic or inorganic film obtained by converting reagent gases to the plasma state on the surface of an agglomerate material.

## Description

The present invention relates to agglomerated stone materials characterised by a vitreous type surface layer deposited by the plasma-enhanced chemical vapour deposition technique (PECVD).

The invention also relates to a process for the preparation of said materials.

The manufacture of agglomerated stone products, designed for use as floor and wall coverings in the building industry or employed in internal decoration as kitchen and bathroom worktops or the like, is a known technique. These composite materials can be manufactured in the form of tiles or slabs up to 4 metres square and over, with thicknesses ranging between 1 and 3 cm, or in blocks with a volume of up to 3 cubic metres, which are subsequently sawn into slabs. The choice of geometry of the semimanufactured product depends on the hardness of the starting raw materials, the required appearance of the finished product, and the productivity required of the manufacturing plant.

The starting raw materials are marble or limestone in general, granite, quartz and silica or feldspathic sands, which can be found in nature in large pieces that need to be crushed, or in granules and sands already crushed by natural events; after being suitably sorted into appropriate grading envelopes, they are bound by synthetic polymers (such as unsaturated polyester resin).

Agglomerated stone products are manufactured by different forming technologies, which can be conducted either at atmospheric pressure or under vacuum. The development of the manufacturing technology has brought about a considerable improvement in the technical and aesthetic quality of the products, due to the possibility of using highly effective compacting means able to form the product with a drastic reduction in binder, replaced by a granular filler.

In the technology used to manufacture agglomerate blocks by vibrocompression under vacuum, the combined action of vibration and pressure in the absence of air causes the granules to move very close together, thus reducing the amount of binder required to fill the gaps between them. The absence of air in the process prevents the formation of macro-porosity between the aggregates and micro-porosity in the binding paste. The initial mixing stage can be conducted in air or under vacuum, depending on the type of plant used.

In all forming techniques, raw materials which are "compatible" with one another must be used to manufacture agglomerates, so that products with special technical and appearance characteristics can be "designed".

In this respect, agglomerates can be defined as composites, because they originate from a combination of two different materials: stone material (granulate) and binder. If classifications based on appearance are ignored, agglomerate products can first be classified according to the quality or type of stone granulate used, ie. whether they consist mainly of calcium carbonate (marble or limestone) or silica (granite, quartz or silica sand).

The granulate affects a number of physical, chemical and mechanical characteristics of the finished product, such as the degree of water absorption, abrasion resistance and chemical resistance.

A second classification of agglomerated products can be based on the grade scale of the granulates in the finished product, and above all on their maximum size. This is because the binder used, and in particular its quantity in the finished product, depends mainly on the maximum diameter of the granulate (in general, the larger the maximum diameter of the granulate, the smaller the binder content, and vice versa), and this influences other characteristics, such as flexural strength and the linear thermal expansion coefficient.

As demonstrated by the success obtained by this product on the market for many years, the improvement and optimisation of the technical characteristics of agglomerates have made these materials increasingly suitable for all applications in the construction and interior decoration industries, due to their compatibility with other construction materials and their chemical inertia towards the environment.

As regards the state of the surface, an agglomerate is an unglazed product, like all natural stones, and for example porcelain tiles in ceramics. This has important consequences on the technical characteristics, performance and durability of the surfaces. A glazed material (also known as vitrified) has a heterogeneous cross-sectional area. Two distinct areas can be distinguished in cross-section: a thin surface layer, the glaze, which constitutes the wearing surface of the material and determines both its appearance and its functional characteristics, and an underlying layer which forms the actual mass of the material and provides the glazed surface with a support suitable to withstand the predictable mechanical stresses.

In unglazed products, such as agglomerates, the surface and mass of the material are identical, and no differences in the material are observed in cross-section, in terms of either colour or composition.

The working life of a glazed product is determined by the durability of the thin surface layer of glaze; once it has been removed or damaged, the tile loses its aesthetic and functional characteristics. These characteristics cannot be restored, and in practice there is no alternative to replacing the material, namely the tile.

In the case of agglomerates, however, removal of the surface layer exposes a new surface identical in composition to the previous one, which will have the same aesthetic and functional characteristics after smoothing or polishing.

However, a glazed surface offers a much wider range of performances, in particular as regards impermeability, washability, possibility of sanitising, etc., due to the vitrified structure of the surface layer, and these characteristics are increasingly in demand for materials designed for the construction industry and used in particular applications (such as the problem of removing graffiti from external walls, or the need for floor and wall coverings in public buildings with particular resistance to the formation of bacterial cultures in their micro-pores).

For agglomerates, a process of glazing of the support, similar to that performed on ceramic materials, is impossible, due to the limited heat resistance of the binders, which could not withstand temperatures close to the melting temperature of the vitreous materials constituting the glaze.

On the contrary, an agglomerate material with a thin vitreous layer adhering to the surface would guarantee characteristics of impermeability, washability and sanitising, and this would mean that a new material with innovative characteristics compared with conventional agglomerates could be marketed to complete the existing range. This material would be particularly suitable for use, for example, as wall coverings, where certain characteristics of ease of cleaning or matching decor are required (kitchen and bathroom worktops, etc.), and the stain-resistance of the surface is essential. The presence of an agglomerate as support, on the laying side, would guarantee that all requirements for correct laying of the tiles are maintained, using metal anchorages or rear packing with adhesives of various kinds.

Composite materials consisting of layered structures are already known: they are generally made because, in order to obtain high flexural strength, for example, it is not necessary to make the whole structure from a high-performance material, as when a slab is stressed to the point of flexure, only the outermost layers are stressed. However, due to the difference in mechanical rigidity between the materials constituting the various layers, considerable shearing loads are often produced at the interface between the different materials, which often leads to delamination, ie. the layers become detached from one another. This problem often makes these materials unsuitable for the many applications possible in the construction and interior decoration fields.

Moreover, with a suitable choice of materials to be combined and the design of a suitable bonding system (adhesive) for the various layers, stratified composite materials can be made which have a set of physical and mechanical properties that none of the individual constituents possess.

In this respect the physico-mechanical properties of glass are known, especially its characteristics of impermeability and transparency. The possibility of making flat, transparent sheets of glass of sufficiently large size is particularly important for applications in the construction industry. Other important properties of glass are its high flexural strength and high resistance to rapid temperature changes. The most typical defect of glass is fragility, ie. low shock resistance, due to the disordered state of its molecular structure which prevents homogenous distribution of forces, thus promoting very rapid accumulation of tensions which lead to breakage.

This limitation affects the use of glass as a structural or covering material if the material is designed to be subjected to stresses, especially shocks, when in operation.

The prior art includes also the low-temperature polymerisation of an organic or inorganic film obtained by converting the reagent gases to the plasma state.

Plasma phase polymerisation, also known as PECVD (plasma-enhanced chemical vapour deposition), enables any type of material to be coated with thin films. The main reagent (monomer), possibly mixed with other gases, is converted to the plasma state at a pressure between 50 Pa and 0.5 Pa: when plasma has been triggered, the monomer is fragmented and bonds to other molecules to form a polymer which will grow on the surface of the product to be treated.

It has surprisingly been found, and this is the object of the invention, that thin films with the composition Siₓ, O_{y}, C_{z} H_{w}, where x, y, z and w are modifiable according to the process used, can be deposited on agglomerated materials by the PECVD (plasma-enhanced chemical vapour deposition) technique, which gives the product all the surface characteristics of glass without the disadvantages previously described.

The films can be applied to agglomerates based on calcium carbonate and polyester resin, in which case the calcium carbonate and polyester resin receive chemical and physical protection, or to agglomerates based on granite/quartz and polyester resin, in which case only the polyester resin receives chemical and physical protection.

Plasma, a gas consisting of electrons and ions not bonded to one another, can exist at a very wide range of temperatures and pressures. As mentioned, in the PECVD (plasma-enhanced chemical vapour deposition) technique, the main reagent (monomer), possibly mixed with other gases, is converted to the plasma state; the monomer instantly fragments and bonds with other molecules to form the polymer, which then grows near the surfaces inside the vacuum chamber.

In particular, films with a composition similar to natural quartz, ie. SiO₂, or silicone films, can be made. In all cases the basic material can be prepared for deposition by "plasma grafting" pretreatment.

"Grafting" means modifying the surface of a material without altering the general properties of the product, with a dry process that does not require solvents or chemicals harmful to the environment.

"Plasma grafting" means grafting particular chemical groups formed in the plasma phase onto the surface of the material to be treated; hydroxyl, amine, fluoride, chloride or other groups can be grafted, depending on the type of plasma used.

This technique is used to convert the surface of a (natural or synthetic) polymer from hydrophobic to hydrophilic by changing its polarity and consequently increasing its wettability and adhesiveness. The treatments are performed at ambient temperature, thus eliminating the risk of heat degradation of the polymers. This technique is generally used as a pretreatment. Using this technique, the products can be microcleaned of organic contaminants, which cleave and evaporate when subjected to plasma grafting (etching reaction).

With the PECVD (plasma-enhanced chemical vapour deposition) technique, the monomers used for the deposition reaction are oxygen and silicon-based organic and inorganic compounds. The process is performed by introducing the reagents in the gaseous state into a chamber in which a vacuum is created and maintained at a pressure of between 50 Pa and 0.5 Pa; the gas is then converted to the plasma state.

Films can also be made with multi-layers in which the composition of said indexes x, y, z and w varies.

The flexibility of plasma treatment means that the properties of the film produced can be adjusted by varying the characteristics of the plasma or adding different gases to the reaction chamber.

It has been found, this is the object of the present invention, that among the polymers which can be deposited, multi-layer or single-layer SiOₓ films and silicone films are particularly important, because they protect the surfaces of calcium carbonate and resin against chemical attack by acid products and against scratches caused by contact with hard materials.

These films, obtainable by nanotechnology methods, are particularly suitable for the chemical and physical protection of surfaces which are not particularly resistant.

According to the invention, single-layer and multi-layer SiOₓ and silicone films can be deposited with the PECVD technique, at a temperature close to ambient temperature, on the surfaces of stone agglomerates consisting of calcium carbonate and polyester resin or granite/quartz and polyester resin, giving said surfaces the chemical and physical properties described above, which are typical of quartz or silicone films.

More in detail, this invention relates to the deposition of synthetic quartz, silicones and multi-layer or single-layer SiOₓ on the surface of a product made of agglomerate material, according to the PECVD (plasma enhanced chemical vapour deposition) technique, at a temperature close to ambient temperature: deposition takes place due to the presence of a plasma (ie. an ionised gas) at low pressure which breaks down the reagents and recombines them to form the quartz film.

Chemically, the reaction can be described as follows: 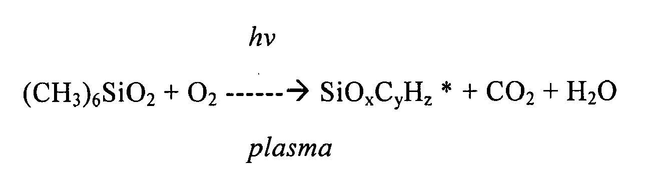 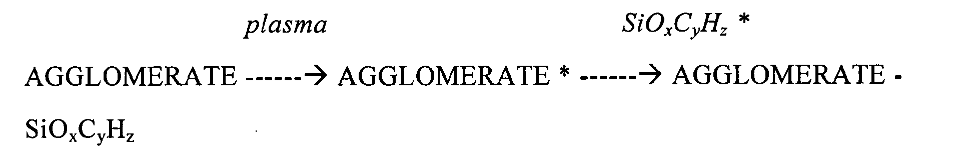 where: * = ion or radical.

The monomer can be hexamethyldisiloxane or any other organic or inorganic compound containing silicon, which is able to evaporate under the reaction conditions.

The film is anchored to the surface of the agglomerate by the excitation undergone by the product during the deposition process and by the relatively low thicknesses deposited (from approx. 0.1 to 30 micrometres, and preferably from 0.1 µ to 10 micrometres).

The high anchorage, accompanied by nanometric thicknesses, provides a surface deposition which is extremely elastic from the mechanical standpoint, and also adaptable to surfaces with complex geometries.

To produce the required reactions, the agglomerated material to be treated is placed in a vacuum chamber. The reagents are converted to the plasma state by supplying energy, in particular electromagnetic energy at a frequency of 13.56 MHz, but similar results can also be obtained with electromagnetic sources in the KHz (low-frequency) and microwave band. Under low pressure conditions (from 0.01 to 1 mbar) the plasma becomes a concentrate of highly reactive species, but at a temperature of between 10 and 40°C.

The vacuum chamber therefore consists of an environment in which plasma is generated; a pumping system to form the vacuum; a radiofrequency generator; and possibly a suitably dimensioned system for handling the products to be treated. The by-products of the reaction are CO₂ + H₂O. The polymer film treatment operation is performed continuously or non-continuously on the agglomerate in the vacuum chamber.

Using the treatments according to this invention, the chemical characteristics of chemical and stain resistance and the physical characteristics of scratch resistance of the agglomerate materials can be increased.

For example, in the case of surface treatment using the PECVD technique of an agglomerate consisting of calcium carbonate and polyester resin with a polymer film constituted by SiOₓC_{y}H_{z}, where x, y and z are integers from 1 to 10, the chemical resistance, stain resistance and scratch resistance results can be summarised as follows:
Chemical resistance to 2% HCl: absolute for 5 minutes.
Chemical resistance to 2% HCl: slight loss of shine after 10 minutes.
Increased absolute resistance to staining with bleach, liquid soap, toothpaste, ammonia, Coca Cola® and red wine: 1 to 24 hours.
Increased scratch resistance from 3 to 4/5 on the Mohs scale.
The test method used to measure the chemical and stain resistance is based on European Standard EN-14617/10, suitably modified, while the test method used to measure scratch resistance is European standard EN-101.
This invention therefore relates to the low-temperature polymerisation of an organic or inorganic film obtained by converting reagent gases to the plasma state on the surface of an agglomerate material under the following process conditions.
This process can conveniently be preceded by "plasma-grafting" pretreatment, which basically involves grafting chemical groups formed at the plasma phase onto the surface to be treated.

The process therefore comprises:
1. Agglomerate support consisting of calcium carbonate and polyester resin or granite/quartz and polyester resin with a thickness of 6 mm to 30 mm.
2. Polymer film composing the monomer precursor consisting of SiOₓ or SiOₓC_{y}H_{z}, where x, y and z are integers or fractions from 0.5 to 20.
3. Thickness of film polymer on agglomerate surface: from approx. 0.1µ to a few micrometres, e.g. 10-30 micrometres.
4. Operating pressure during plasma formation: 50 Pa to 0.5 Pa.
5. Energy supplied for plasma formation at a frequency of 13 to 14 MHz.
6. Main by-products of plasma formation reaction: CO₂ and H₂O and unreacted monomer.
7. Reaction times in plasma formation and film deposition: 30 seconds to 1 hour.
8. Reaction temperature in plasma formation and film deposition: 10 to 40°C.

The characteristics of this cold-plasma surface treatment process can be summarised as follows:
- low use of reagents,
- no recovery and disposal of by-products,
- treatment at a temperature close to ambient temperature,
- possibility of exposure of polymer on surface without degradation,
- low energy and gas consumption,
- dry process not requiring solvents,
- modification of surface without any alteration of the general properties of the product.

### EXAMPLE

The agglomerated stone product used for the tests took the form of a tile measuring 30 x 30 cm with a thickness of 12 mm.

The product had the following composition:
- calcium carbonate powders: between 20 and 30% in volume
- calcium carbonate chippings: between 50 and 65% in volume
- orthophthalic unsaturated polyester resin plus additives required for the crosslinking process (reaction catalysts and reaction accelerators): between 15 and 20% in volume
- white pigment.

The product was formed by vibration and simultaneous compression under vacuum, and subsequently cross-linked at a temperature of 20°C; it was then reduced to the necessary size for the experiment by cutting to the required format.

The process of deposition of the polymer film on the surface of the material according to the PECVD technique comprises the following stages:
- Polymer film composing the monomer precursor consisting of SiOₓ or SiOₓC_{y}H_{z}, where *x, y* and *z* have values from 0.5 to 20.
- Thickness of polymer film deposited on surface of agglomerate: approx. 3 µ.
- Operating pressure during plasma formation: 10 Pa.
- Energy supplied for plasma formation at a frequency of 13.5 MHz.
- Reaction time in plasma formation and film deposition: 1 hour.
- Reaction temperature in plasma formation and film deposition: 20°.

The surface characteristics acquired by the product were as follows:
- Chemical resistance to 2% HCl: absolute for 5 minutes.
- Chemical resistance to 2% HCl: slight loss of shine after 10 minutes.

The surface characteristics obtained in the final product have been the following:
- Increase in absolute resistance to staining with bleach, liquid soap, toothpaste, ammonia, Coca Cola® and red wine: 1 to 24 hours.
- Increase in scratch resistance from 3 to 4/5 on the Mohs scale.

## Claims

1. Agglomerated stone materials **characterised by** a surface layer deposited with the plasma-enhanced chemical vapour deposition (PECVD) technique, said layers having a chemical composition definable as Siₓ, O_{y}, C_{z}, H_{w}, wherein x, y, z and w can be modified depending on the process used.

2. Agglomerated stone materials as claimed in claim 1, wherein the surface layer is a layer of silicone or single- or multi-layer SiOₓ

3. Stone materials as claimed in claim 2, wherein the silicone layer is a layer with the composition SiOₓC_{y}H_{z}, where x, y and z, which are equal or different, are between 0.5 and 20, and preferably integers from 1 to 10.

4. Stone materials as claimed in any one of claims 1 to 3, wherein the thickness of the layer deposited by PECVD is between approx. 0.1 µ and 10 micrometres.

5. Stone materials as claimed in any one of claims 1 to 4, wherein the stone agglomerates are agglomerates of calcium carbonate and polyester resin.

6. Stone materials as claimed in any one of claims 1 to 4, wherein the stone agglomerates are agglomerates of granite/quartz and polyester resin.

7. Process for the preparation of stone materials as claimed in claims 1 to 6, which comprises polymerisation on a stone agglomerate of a suitable monomer in plasma phase by irradiation with a frequency of between 13 and 14 MHz, possibly in the presence of other gases at a pressure of between 50 Pa and 0.5 Pa.

8. Process as claimed in claim 7, wherein the reaction times in plasma formation and film deposition are between 30 seconds and one hour.

9. Process as claimed in claim 7 or 8, wherein the reaction temperature in plasma formation and film deposition is between 10 and 40°C.

10. Process as claimed in any one of claims 7 to 9, wherein the agglomerates are agglomerates of calcium carbonate or quartz/granite and polyester resin.

11. Process as claimed in any one of claims 7 to 10, wherein the monomer is hexamethyldisiloxane.
